# FASCICULE DE BREVET EUROPEEN

(11) **EP 2 922 088 B1**
(45) Date de publication et mention de la délivrance du brevet: **28.04.2021**
(21) Numéro de dépôt: 15159571.7
(22) Date de dépôt: 18.03.2015
(51) Int. Cl.: H01L 21/768, H01L 21/3065

(54) **Procédé de gravure d'un matériau diélectrique poreux**
Ätzverfahren eines porösen dielektrischen Materials
Method for etching a porous dielectric material

(30) Priorité: 18.03.2014 FR 1452221
(43) Date de publication de la demande: 23.09.2015
(73) Titulaire: COMMISSARIAT À L'ÉNERGIE ATOMIQUE ET AUX ÉNERGIES ALTERNATIVES, 75015 Paris (FR)
(72) Inventeur: Posseme, Nicolas, 38000 GRENOBLE (FR)
(74) Mandataire: Hautier, Nicolas

(56) Documents cités:
- US-A1- 2001 046 781
- US-A1- 2004 028 916
- US-A1- 2007 077 782
- NAKAGAWA H ET AL: "CH4/N2 PLASMA ETCHING FOR ORGANIC LOW-K DIELECTRIC MATERIAL", JAPANESE JOURNAL OF APPLIED PHYSICS, JAPAN SOCIETY OF APPLIED PHYSICS, JP, vol. 41, no. 9, PART 01, 1 septembre 2002 (2002-09-01), pages 5775-5781, XP001163821, ISSN: 0021-4922, DOI: 10.1143/JJAP.41.5775
- N. POSSEME ET AL: "A Novel Low-Damage Methane-Based Plasma Ash Chemistry ( CH4 / Ar ) : Limiting Metal Barrier Diffusion into Porous Low-k Materials", ELECTROCHEMICAL AND SOLID-STATE LETTERS, vol. 8, no. 5, 1 mai 2005 (2005-05-01), pages G112-G114, XP055165357, ISSN: 1099-0062, DOI: 10.1149/1.1887199

## Description

### DOMAINE DE L'INVENTION

La présente invention est relative à l'utilisation de matériaux diélectriques poreux à faible permittivité pour la réalisation de lignes d'interconnexion électriques pour des dispositifs microélectroniques et notamment dans les circuits intégrés. Elle concerne, plus particulièrement, un procédé de gravure amélioré de tels matériaux.

### ARRIERE-PLAN TECHNOLOGIQUE

Afin de répondre aux exigences de taille des dispositifs et de temps de commutation en microélectronique, le procédé de réalisation de lignes d'interconnexion, lesquelles lignes nécessitant une isolation par un matériau diélectrique poreux, a dû être adapté. En outre, la réalisation de tranchées étroites dans le matériau diélectrique poreux, SiOCH par exemple, nécessite de revoir les différents procédés par plasma (gravure, traitements post-gravure) et les schémas d'intégration, puisque ce matériau est connu pour être facilement dégradé lorsqu'il est exposé à un plasma à base de fluor, notamment. Les études faites pour évaluer l'efficacité de différents plasmas en fonction des matériaux exposés aux plasmas permettent de caractériser et d'optimiser les procédés de transfert de motifs d'un masque métallique ou organique dans un SiOCH poreux ou hybride (rendu poreux en fin d'intégration). Un problème majeur est la modification des matériaux diélectriques poreux et hybrides lors de plasma « post-gravure ». Avec un plasma fluorocarboné, le matériau hybride présente des mécanismes de gravure similaires à ceux d'un SiOCH dense. Le matériau de type nitrure de titane (TiN) et le matériau organique ont des mécanismes de gravure différents de ceux des diélectriques, ce qui assure une bonne sélectivité. Le procédé de gravure optimisé pour le masque organique permet la gravure de tranchées très étroites avec un profil quasiment vertical.

Lors du procédé de réalisation de lignes d'interconnexion, une des étapes critiques demeure la gravure de la couche de matériau diélectrique poreux. Le principal inconvénient d'une gravure plasma à base de fluor dans un dispositif comprenant un masque dur métallique et une couche de matériau diélectrique poreux est la génération de résidus provenant de l'interaction entre des espèces chimiques présentes dans le plasma et sur le masque métallique ; lesdits résidus se déposant sur les couches et provoquant par la suite des défaillances des dispositifs réalisés. Ce phénomène de formation de résidus lors d'une gravure plasma à base de fluor et de carbone est notamment décrit dans la publication en anglais : «Residue growth on metallic-hard mask after dielectric etching in fluorocarbon-based plasmas. I. Mechanisms », N. Posseme et al, J. Vac. Sci. Technol. B 28(4), Jul/Aug 2010, pp. 809-816

Dans le document de Nakagawa et al (Jpn. J Appl. Phys. Vol. 41 (2002) pp. 5775-5781) la gravure d'un diélectrique low-k non-poreux avec un plasma en base de CH4 est décrite.

Dans le document US 2007/0077782 A1 la gravure des diélectriques low-k poreux et non-poreux est décrite.

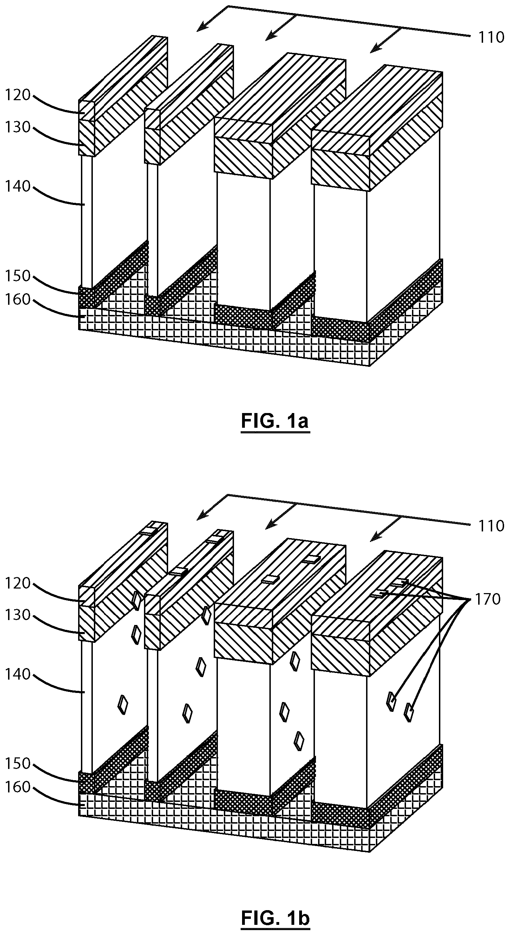

D'autres inconvénients de la gravure plasma à base de fluor sont évoqués ci-après et illustrés dans les figures 1a à 1c. Ces figures représentent en particulier les différents problèmes générés par la gravure du diélectrique poreux, le p-SiOCH, à partir d'un plasma fluorocarboné et par l'utilisation d'un masque dur en nitrure de titane (TiN).

La **figure 1a** illustre la structure des lignes d'interconnexion après gravure dans un plasma fluorocarboné du matériau poreux utilisé comme diélectrique, le p-SiOCH, et avant remplissage des tranchées 110, comme cela est mis en œuvre dans le procédé conventionnel dit « damascène » de formation des interconnexions de cuivre.

La gravure se fait en utilisant un masque dur 120, typiquement fait de nitrure de titane (TiN), qui recouvre une couche 130 d'oxyde de silicium (SiO₂) servant de couche d'arrêt lors de l'étape de polissage mécano-chimique (de l'acronyme CMP en anglais pour « Chemical Mechanical Polishing ») en vue de la réalisation ultérieure de lignes d'interconnexion à base de cuivre par exemple avec le procédé « damascène ». Préalablement au dépôt de la couche 130 d'oxyde de silicium, est formée une couche de matériau diélectrique poreux 140, par exemple de SiOCH. Sous la couche de matériau diélectrique poreux 140 se trouve une couche 150 servant de couche d'arrêt lors de la gravure plasma. La couche globale 160 symbolise toutes les couches sous-jacentes du circuit intégré, notamment celles contenant des composants actifs qui sont réalisés lors des étapes préliminaires du procédé, celles qui précèdent les opérations dites « BEOL » acronyme de l'anglais « Back-End Of Line » ou étapes de « fin de ligne » au cours desquelles on réalise, à des températures relativement faibles, tous les niveaux d'interconnexions entre les composants actifs et où l'on va graver successivement toutes les couches diélectriques.

La figure 1a illustre un premier problème lié à la plus grande sensibilité du matériau diélectrique poreux 140 lors de la gravure conventionnelle dans un plasma fluorocarboné. Une consommation plus importante du matériau diélectrique poreux 140 est observée correspondant à une sur-gravure de cette couche 140. Par ailleurs, on peut également rencontrer des problèmes d'absorption d'humidité qui pourraient engendrer une augmentation de la constante diélectrique du matériau diélectrique à faible permittivité ; ce qui va à l'encontre du but recherché et affecte aussi la fiabilité du dispositif réalisé.

La **figure 1b** illustre un problème supplémentaire qui a trait à l'utilisation d'un masque dur 120 métallique. Après gravure, les tranchées 110 sont inévitablement exposées à l'air libre, engendrant un dépôt et une formation de résidus 170 sur la paroi des tranchées 110. La formation de ces résidus 170 est d'autant plus importante que les tranchées 110 sont laissées plus longtemps à l'air libre. Le mécanisme de formation des résidus 170 est associé aux espèces fluorées présentes sur le masque dur 120 en métal et sur les surfaces du matériau diélectrique poreux 140 à faible permittivité, après gravure dans le plasma fluorocarboné. Les espèces fluorées réagissent alors à l'humidité de l'air produisant de l'acide fluorhydrique (HF) qui forme des sels métalliques au contact du masque dur 120. Ces résidus 170 affectent la qualité des dépôts suivants : celle de la couche faisant barrière à la diffusion du cuivre, et celle de la couche de cuivre qui va servir à former toutes les lignes d'interconnexion métalliques (l'utilisation du cuivre requiert le dépôt préalable d'une couche destinée à empêcher la diffusion de ce dernier dans le matériau semiconducteur servant à la réalisation des transistors, généralement en silicium). Ces résidus 170 peuvent produire des vias intempestifs entre lignes (par exemple, des court-circuits) et des ruptures de lignes (par exemple, des circuits ouverts) qui affectent très significativement le rendement de fabrication des dispositifs réalisés.

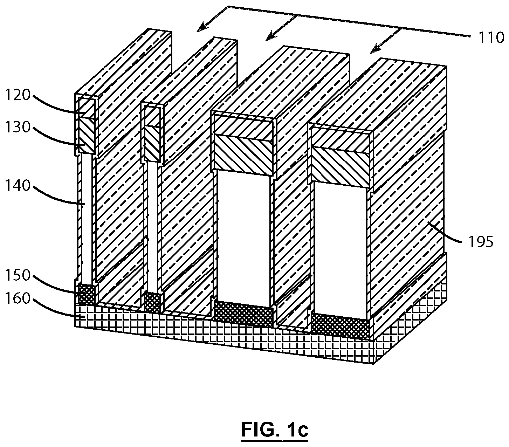

La **figure 1c** illustre encore un autre problème qui est lié au nettoyage par voie humique basé sur l'emploi d'acide fluorhydrique (HF) et qui s'avère n'être pas assez efficace pour éliminer toute la couche fluorocarbonée formée lors de la gravure. Après le nettoyage humide, il reste du fluor sur les flancs des tranchées 110. Le fluor est encapsulé lors du dépôt de la couche 195 faisant office de barrière métallique et qui doit être déposée avant le dépôt de cuivre pour éviter la migration de ce dernier. Le fluor a tendance à diffuser et peut conduire à une dégradation de fiabilité du matériau diélectrique poreux 140, par exemple le p-SiOCH. Un nettoyage humide agressif, qui enlèverait toute la couche de fluor, aurait pour inconvénient de conduire à une perte de définition des dimensions critiques des dispositifs réalisés.

Par conséquent, l'introduction de matériaux diélectriques poreux à faible permittivité nécessaire pour réduire la constante de temps des interconnexions entre composants actifs d'un circuit intégré, et notamment la gravure de ces matériaux diélectriques poreux dans un plasma fluorocarboné, posent de nombreux problèmes.

Un objet de la présente invention propose un procédé de réalisation de lignes d'interconnexion limitant, voire supprimant, au moins certains des problèmes et inconvénients mentionnés ci-dessus, et notamment les problèmes générés lors de l'étape de gravure de matériaux diélectriques poreux à partir d'un plasma à base de composés fluorocarbonés.

### RESUME DE L'INVENTION

La présente invention concerne un procédé selon la revendication 1.

De manière particulièrement avantageuse, l'étape de gravure du procédé selon l'invention permet de former une tranchée dont les flancs et le fond sont dépourvus de résidus. Ainsi, lors de l'étape de remplissage des tranchées, la limitation de dépôts résiduels sur les flancs améliore la qualité de conduction du matériau de remplissage, et de ce fait, favorise la fiabilité des lignes d'interconnexion.

La gravure est réalisée à partir d'un plasma comprenant au moins un gaz à base d'hydrocarbure. Avantageusement, tous les composées de type C_{X}H_{Y}, où X est la proportion de carbone et Y la proportion d'hydrogène, sont susceptibles de convenir. A titre préféré, le gaz formant le plasma comprend du méthane (CH₄).

De manière particulièrement avantageuse, la couche de protection, à base d'hydrocarbure, qui se développe pendant la gravure, protège le matériau diélectrique poreux de toute contamination ou modification.

Le mélange de gaz formant le plasma comprend également de l'azote (N₂) ou de l'oxygène (O₂). En outre, l'azote permet de graver le matériau diélectrique poreux et de contrôler la quantité de carbone déposé sur les flancs.

L'invention porte sur un procédé de réalisation d'une ligne d'interconnexion électrique. Le procédé comprend la gravure d'un motif formant une tranchée selon les étapes de l'invention. Il comprend également une étape ultérieure de remplissage de la tranchée par un matériau électriquement conducteur.

Le motif forme une tranchée.

Selon une option, la gravure définit un motif dans une couche de matériau diélectrique poreux et comprend, préalablement à la gravure, la définition du motif dans un masque surmontant la couche de matériau diélectrique poreux, la gravure de la couche de matériau diélectrique poreux étant ensuite effectuée à travers le masque.

Selon un autre mode de réalisation, l'invention porte sur un procédé de gravure d'au moins un motif dans une couche de matériau diélectrique poreux. Le procédé comprend : la définition du motif dans un masque surmontant la couche de matériau diélectrique poreux, au moins une gravure de la couche de matériau diélectrique poreux à travers le masque. La gravure est réaliseé dans un plasma comprenant un gaz à base d'hydrocarbure et d'azote (N₂) ou d'oxygène (O₂), de manière à former tout au long de ladite gravure une couche de protection, au moins sur les flancs de la couche de matériau diélectrique poreux.

Le but de l'invention est de développer un procédé de réalisation de lignes d'interconnexion comprenant en outre une étape de gravure chimique d'une couche de matériau diélectrique poreux formant une tranchée. Avantageusement, cette étape de gravure réduit voire supprime les dommages et/ou la formation de résidus sur les flancs de la couche de matériau diélectrique poreux.

Avantageusement, la formation d'une couche de protection sur les flancs de la couche de matériau diélectrique poreux permet, au matériau diélectrique poreux, de conserver ses propriétés électriques et notamment une faible permittivité. De manière particulièrement avantageuse, la limitation de dépôts résiduels et la formation d'une couche de protection sur les flancs de la couche de matériau diélectrique poreux permettent de favoriser la conduction du matériau de remplissage et ainsi améliorent la fiabilité des lignes d'interconnexion.

Selon un autre mode de réalisation, la présente invention concerne un procédé de gravure d'une couche de matériau diélectrique poreux. La gravure est réalisée dans un plasma de manière à faire croître tout au long de ladite gravure une couche de protection au moins sur des flancs de la couche de matériau diélectrique poreux. Le plasma est formé à partir d'un gaz formé d'un premier composant et d'un deuxième composant, ou d'un gaz formé d'un premier composant, d'un deuxième composant et d'un troisième composant. Le premier composant est un hydrocarbure de type C_{X}H_{Y}, où X est la proportion de carbone dans le gaz et Y la proportion d'hydrogène (H) dans le gaz ; le deuxième composant est pris parmi l'azote (N₂) ou le dioxygène (O₂) ou un mélange d'azote et de dioxygène ; le troisième composant est pris parmi l'argon (Ar) ou l'hélium (He).

### BREVE INTRODUCTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1a à 1c illustrent les différents problèmes générés par la gravure du matériau diélectrique poreux, par exemple le p-SIOCH, à partir d'un plasma fluorocarboné.
La FIGURE 2 résume les étapes principales du procédé de l'invention et les différences d'avec le procédé standard de gravure du matériau diélectrique poreux, pour y former des tranchées.
Les FIGURES 3a à 3h illustrent les différentes étapes du procédé de l'invention en vue de la réalisation de lignes d'interconnexion.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et films ne sont pas représentatives de la réalité.

### DESCRIPTION DETAILLEE

Il est précisé que dans le cadre de la présente invention, le terme « sur » ou « sous-jacent » ne signifient pas obligatoirement « au contact de ». Ainsi, par exemple, le dépôt d'une première couche sur une deuxième couche , ne signifie pas obligatoirement que les deux couches sont directement au contact l'une de l'autre mais cela signifie que la première couche recouvre au moins partiellement la deuxième couche en étant soit directement à son contact, soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi les épaisseurs sont généralement prises selon une direction verticale sur les figures représentées. En revanche, l'épaisseur d'une couche recouvrant un flanc d'un motif est prise selon une direction perpendiculaire à ce flanc.

Avant d'entamer une revue détaillée de modes de réalisation de l'invention, sont énoncées ci-après des caractéristiques optionnelles qui peuvent éventuellement être en association ou alternativement :
Selon un mode de réalisation particulièrement avantageux, le ratio de gaz entre le premier composant et le deuxième composant est compris entre 5% et 20%
Selon un mode de réalisation particulièrement avantageux, le ratio de gaz entre le premier composant et le deuxième composant est supérieur à 1:20 et inférieur à 1:10. Le risque d'utiliser un ratio de mélange gazeux, par exemple de méthane/azote, supérieur à 1:10 est d'empêcher la gravure du matériau diélectrique poreux. Le risque d'utiliser un ratio de mélange gazeux, par exemple de méthane/azote, inférieur à 1:20 est de modifier le matériau diélectrique poreux. Typiquement le ratio est un rapport du débit du premier composant sur le début du deuxième composant. Ces débits peuvent s'exprimer en sscm acronyme de l'anglais standard cubic centimeters per minute signifiant centimètres cubiques standard par minute.

Avantageusement, le plasma comprend de l'azote (N₂). Le film diélectrique poreux est gravé suite au bombardement ionique à base d'azote.

Selon un mode de réalisation, le plasma comprend du dioxygène (O₂).

Avantageusement, le plasma comprend également de l'argon (Ar) ou de l'hélium (He).

De préférence, pour ajuster l'épaisseur de la couche de protection, on modifie la concentration en hydrocarbure formant le plasma. Typiquement, on augmente la concentration en hydrocarbure formant le plasma pour augmenter l'épaisseur de la couche de protection. Il convient cependant de ne pas avoir une concentration trop élevée pour ne pas empêcher la gravure.

De manière particulièrement avantageuse, la couche de protection à base d'hydrocarbure formée lors de la gravure isole électriquement les flancs du matériau diélectrique poreux.

Avantageusement, on conserve la couche de protection formée lors de la gravure. Selon un mode de réalisation, on dépose une couche additionnelle sur la couche de protection afin de former des interconnexions.

Le matériau diélectrique poreux est un oxyde de silicium dopé au carbone et à l'hydrogène (SiOCH) poreux.

Avantageusement, avant la gravure de la couche de matériau diélectrique poreux, on réalise un masque dur surmontant la couche de matériau diélectrique poreux, le masque dur présentant au moins un motif et la gravure de la couche de matériau diélectrique poreux étant effectuée à travers le masque dur pour transférer le motif dans la couche de matériau diélectrique poreux.

De préférence, le masque dur est fait d'oxyde de silicium (SiO₂), de nitrure de silicium (SiN) ou de SiOCH dense.

Avantageusement, le masque dur présente une face inférieure au contact de la couche de matériau diélectrique poreux et une face supérieure opposée à la face inférieure et dans lequel ladite face supérieure est au contact de la solution de gravure lors de l'étape de gravure de la couche de matériau diélectrique poreux à travers le masque dur.

Avantageusement, l'épaisseur du masque dur est adaptée pour ne pas être entièrement consommé pendant la gravure plasma de la couche de matériau diélectrique poreux.

Préférentiellement, le masque dur est un masque métallique.

Avantageusement, préalablement à la définition du motif dans le masque dur, on dispose, sous la couche de matériau diélectrique poreux, une couche d'arrêt conformée pour stopper la gravure de la couche de matériau diélectrique poreux, et on effectue après l'étape de gravure de la couche de matériau diélectrique poreux, une étape de gravure de la couche d'arrêt.

Selon un mode de réalisation, préalablement à la définition du motif du masque dur, on dispose sous la couche de matériau diélectrique poreux une couche d'arrêt qui, lorsqu'elle est soumise au plasma utilisé pour graver la couche de matériau diélectrique poreux, présente une vitesse de gravure inférieure à la vitesse de gravure de la couche de matériau diélectrique poreux, et dans lequel on grave la couche d'arrêt à la suite de la gravure de la couche de matériau diélectrique poreux en utilisant ledit plasma.

Avantageusement, le motif est une tranchée, le procédé comprenant, après la gravure de la couche de matériau diélectrique poreux, une étape ultérieure de remplissage de la tranchée par un matériau électriquement conducteur.

De préférence, la tranchée forme une ligne d'interconnexion électrique.

Avantageusement, avant l'étape de gravure, le matériau diélectrique poreux recouvre une grille d'un transistor et la gravure est effectuée de manière anisotrope selon une direction principale parallèle à des flancs de la grille, de sorte à retirer la couche de matériau diélectrique poreux uniquement en dehors des flancs du transistor pour former des espaceurs pour la grille.

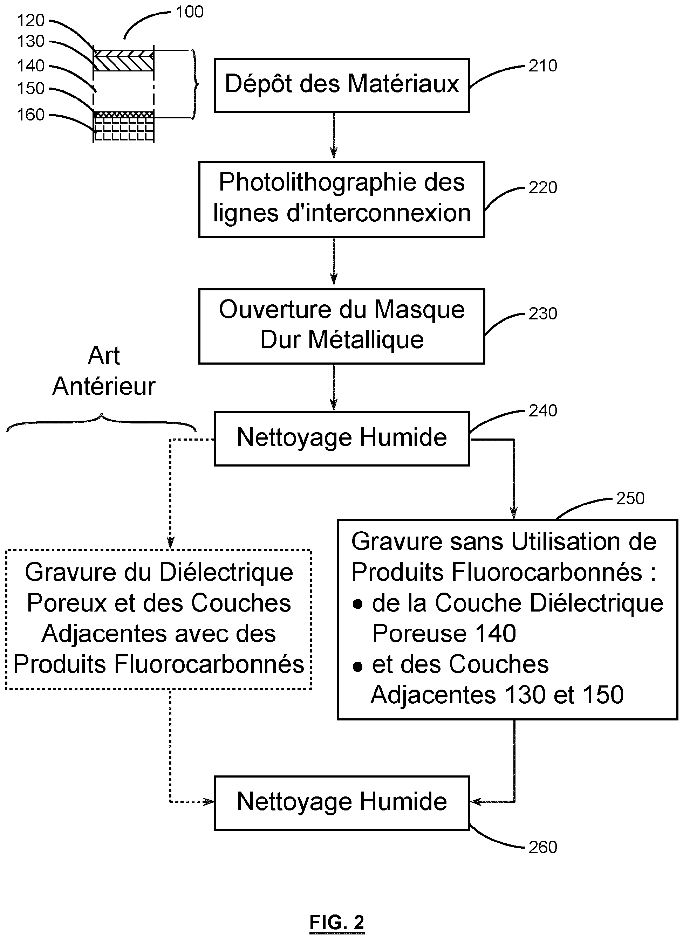

La **figure 2** résume les étapes de gravure du matériau diélectrique poreux 140 selon le procédé de l'invention et souligne les différences d'avec le procédé standard.

On procède tout d'abord au dépôt 210 des différentes couches de matériaux incluant la couche de matériau diélectrique poreux 140 dans laquelle on va graver les lignes d'interconnexion. On retrouve les différentes couches déjà décrites qui sont, dans l'ordre où elles sont déposées: la couche 150 servant de couche d'arrêt à la gravure, la couche de matériau diélectrique poreux 140, la couche d'oxyde 130, le masque dur 120 métallique. Dans cette structure stratifiée 100, la couche globale 160 ou empilement de couches symbolise l'ensemble des couches sous-jacentes dans lesquelles ont été préalablement réalisés les composants actifs c'est-à-dire les transistors.

De manière avantageuse mais non limitative, les épaisseurs et matériaux des couches ci-dessus sont :
- Le masque dur 120 métallique est préférentiellement formé à base de nitrure de silicium (TiN), dans une gamme d'épaisseur comprise entre 5 et 100 nanomètres (nm) et, de préférence, entre 10 et 50 nm. Dans le cadre de la présente invention, le masque dur 120 métallique peut également être réalisé en nitrure de tantale (TaN) ou en nitrure de bore (BN).
- La couche 130 d'oxyde est, de préférence, à base d'oxyde de silicium (SiO₂), dans une gamme d'épaisseur allant de 10 à 50 nm. Elle sert de couche d'arrêt pour l'étape de polissage mécano-chimique (CMP) qui est effectuée lors de la formation des interconnexions avec le procédé « damascène ».
- La couche de matériau diélectrique poreux 140 est formée à base de SiOCH poreux. Son épaisseur est comprise entre 50 et 120 nm. Cette couche peut être déposée par centrifugation, opération qui est généralement qualifiée du terme anglais de « spin coating », c'est-à-dire d'un dépôt par étalement à l'aide d'une « tournette ». Le dépôt de SiOCH se fait sous forme liquide sur la tranche en rotation et dans sa forme poreuse finale. On peut aussi procéder par voie sèche à un « dépôt chimique en phase vapeur assisté par plasma » ou « PECVD » acronyme en l'anglais de « plasma-enhanced chemical vapor déposition ». Le dépôt se fait alors en deux étapes à partir de deux gaz précurseurs : l'un pour générer la matrice dense de matériau diélectrique poreux SiOCH, l'autre pour former la structure porogène dans laquelle on peut faire varier la proportion volumique de pores. Dans les deux cas, la porosité du matériau diélectrique 140 est, de préférence, comprise entre 10% et 50% de sorte à assurer une bonne efficacité de la gravure. La chimie de la gravure de l'invention n'est pas limitée au matériau diélectrique poreux
   SiOCH. Elle peut également se pratiquer avec d'autres matériaux tels que l'oxyde de silicium (SiO₂) et le nitrure de silicium (SiN).
- La couche 150 d'arrêt de gravure est typiquement d'une épaisseur allant de 10 à 20 nm. Elle peut être constituée des matériaux suivants utilisés de façon standard pour les opérations de fin de ligne de fabrication (BEOL) : carbure de silicium (SiCH), nitrure de silicium (SiN) ou carbonitrure de silicium (SiCN). La couche 150 d'arrêt joue avantageusement un rôle de protection empêchant la contamination du matériau diélectrique poreux 140 par des matériaux contaminants tels que le cuivre, qui sont présents dans les niveaux inférieurs, c'est-à-dire dans les couches sous-jacentes de la couche globale 160.

L'étape suivante 220 consiste à définir par photolithographie classique, en utilisant une résine photosensible, les motifs de lignes d'interconnexion qui vont devoir être gravés dans la couche de matériau diélectrique poreux 140. Pour ce faire, on a recours à un masque dur métallique 120. Les motifs sont d'abord transférés dans la couche 120 généralement formée de nitrure de titane (TiN). Les motifs définis dans la couche de résine (non représentée) sont donc ouverts à l'étape suivante 230 dans cette couche. L'utilisation d'un masque dur est optionnelle dans le cadre de la présente invention. Ces étapes sont suivies d'une étape de nettoyage par voie humide 240.

L'invention diffère essentiellement du procédé standard en ce que la gravure de la couche 130 faite de SiO₂, de la couche de matériau diélectrique poreux 140 faite de SiOCH poreux et de la couche 150 d'arrêt, qui est réalisée à l'étape suivante 250, se fait sans mettre en œuvre de produits fluorés.

Comme cela sera expliqué par la suite, on réalise la gravure de la couche de matériau diélectrique poreux 140 poreux faite de SiOCH dans un plasma à base d'hydrocarbure et d'azote (N₂) et/ou d'oxygène (O₂) ; ledit plasma étant exempt de tout composé fluoré. De préférence, et dans l'exemple ci-dessous, le plasma comprend uniquement un hydrocarbure, de l'azote et, de manière optionnelle mais avantageuse, de l'argon (Ar) ou de l'hélium (He).

Dans les deux cas, l'opération de gravure peut être suivie d'une nouvelle étape de nettoyage par voie humide 260 nécessaire pour retirer toutes les impuretés présentes en surface.

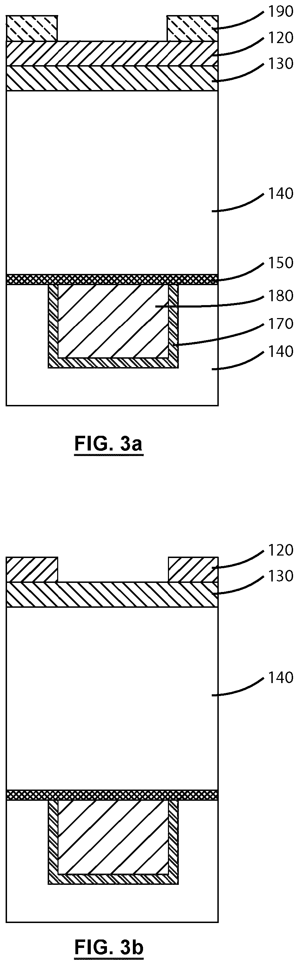

Les figures 3a à 3h détaillent les étapes du procédé de l'invention.

La **figure 3a** est une vue en coupe d'un dispositif comprenant une première ligne d'interconnexion à un premier niveau N-1. Cette première ligne d'interconnexion est, de préférence, formée en un matériau métallique 180. Le matériau métallique est préférentiellement du cuivre. Selon un mode de réalisation avantageux, la ligne de métallisation est protégée par une couche anti-diffusion 170. Cette couche anti-diffusion 170 agit comme une couche de barrière à la diffusion du matériau métallique 180 formant la ligne d'interconnexion. Cette couche anti-diffusion comprend, par exemple, une bicouche de titane et de nitrure de titane, de préférence déposée par une technique de déposition en phase vapeur. Ce premier niveau N-1 est isolé par une couche d'arrêt 150 recouverte d'une nouvelle couche de matériau diélectrique poreux 140 formant un deuxième niveau N. Cette couche d'arrêt 150 joue avantageusement un rôle de protection empêchant la contamination du matériau diélectrique poreux 140 du deuxième niveau N par des matériaux contaminants tels que le cuivre, qui sont présents dans le premier niveau N-1, par exemple. La couche d'arrêt 150 peut être formée de matériaux tels que le nitrure de silicium (SiN), le carbure de silicium nitruré (SiCN), etc.

Afin de réaliser une deuxième ligne d'interconnexion au deuxième niveau N, à partir de la couche de matériau diélectrique poreux 140, une série d'étapes est requise. On forme tout d'abord une couche d'oxyde 130 sur la couche de matériau diélectrique poreux 140. Ensuite une couche formant le masque dur 120 métallique est réalisée. Afin de former un motif au travers, respectivement, du masque dur 120, de la couche d'oxyde 130 et de la couche de matériau diélectrique poreux 140, on réalise une étape préliminaire de lithographie comprenant une étape de formation d'une couche 190, de préférence de résine, sur le masque dur 120 métallique.

La **figure 3b** illustre l'étape de gravure partielle du masque dur 120. Selon un exemple de réalisation non limitatif de l'invention, le nitrure de titane (TiN) formant le masque dur 120 est retiré sélectivement par gravure chimique à base de chlore (Cl₂) dans un appareillage dédié à la gravure du métal dans lequel on forme un plasma chloré. Par gravure sélective d'une couche, on entend le retrait de ladite couche uniquement au niveau des motifs définis par la précédente étape de lithographie, de sorte à atteindre une couche inférieure.

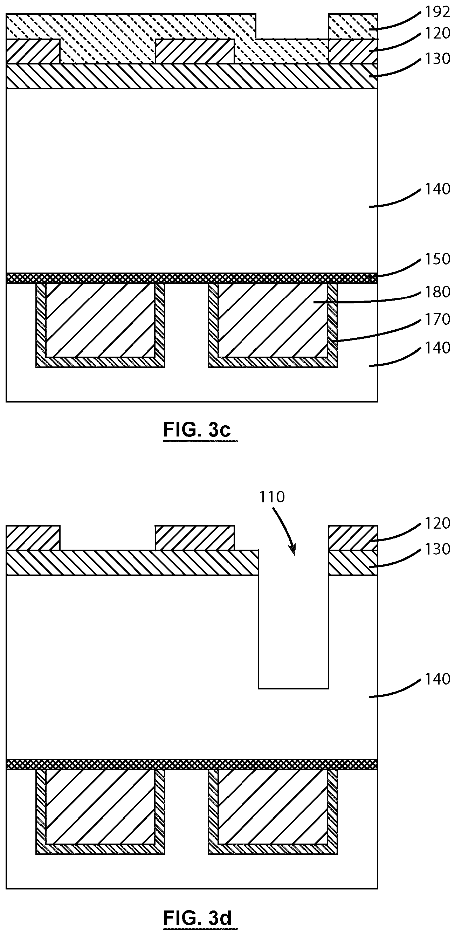

La **figure 3c** illustre une nouvelle étape de lithographie consistant en la définition d'un motif définissant une tranchée. Selon ce mode de réalisation, une couche 192, de préférence de résine, est déposée à l'issue de l'étape de gravure du masque dur 120. Le motif est préférentiellement formé au niveau des motifs définis par la précédente étape de lithographie.

La **figure 3d** illustre le résultat de l'étape de gravure de la couche d'oxyde 130, de préférence de dioxyde de silicium (SiO₂), et de la couche de matériau diélectrique poreux 140, de sorte à former une ouverture 110 au travers de la couche d'oxyde 130 et de la couche de matériau diélectrique poreux 140.

La gravure de la couche d'oxyde 130 peut être réalisée au moyen d'une chimie fluoro-carbonée. Contrairement au procédé conventionnel, avec l'invention, on réalise la gravure de la couche de matériau diélectrique poreux 140 faite de SiOCH dans un plasma à base d'hydrocarbure et d'azote (N2) et/ou d'oxygène (O2) ; ledit plasma étant avantageusement exempt de tout composé fluoré. De préférence, et dans l'exemple ci-dessous, le plasma comprend uniquement un hydrocarbure, de l'azote et, de manière optionnelle mais avantageuse, de l'argon (Ar) ou de l'hélium (He).

Avantageusement, il s'agit d'une gravure physico-chimique, mettant en jeu à la fois un bombardement ionique et une réaction chimique entre le gaz ionisé (plasma) et la surface exposée au bombardement ionique. Le rôle de l'azote (N₂) est en outre de graver le film de SiOCH poreux.

Le gaz à base d'hydrocarbure, utilisé lors de la gravure plasma, forme une enveloppe protectrice au moins sur les flancs de la couche de matériau diélectrique poreux 140, laissant une couche de protection au moins sur lesdits flancs et le fond.

A l'issue de cette gravure, une ouverture 110 est formée au travers de la couche d'oxyde 130 et de la couche de matériau diélectrique poreux 140. La couche de résine 192 préalablement déposée fait office de masque de protection pour les zones n'étant pas destinées à être gravées, localisant le retrait desdites couches 130, 140 uniquement au niveau des motifs définis par la précédente étape de lithographie. Il s'ensuit une étape de retrait de la couche de résine 192. Le retrait de la couche de résine 192 est, par exemple, réalisé à l'aide d'une gravure plasma au moyen d'espèces présentes dans le réacteur comme l'oxygène (O₂). Lors du retrait de la couche de résine 192, la couche de protection formée au moins sur les flancs et le fond de l'ouverture 110 est retirée.

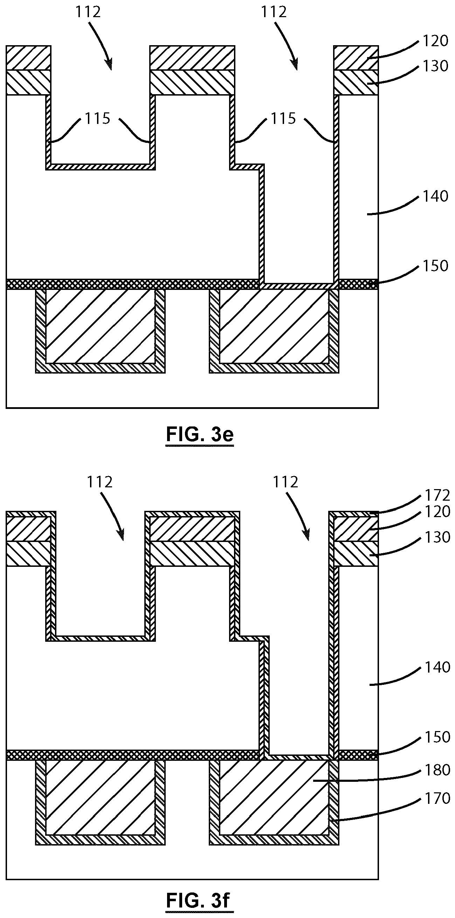

La **figure 3e** illustre le résultat de l'étape de gravure de la couche d'oxyde 130 et de la couche de matériau diélectrique poreux 140. Comme indiqué par la suite, la chimie de la gravure de la couche 130 de SiO₂ et de la couche de matériau diélectrique poreux 140 peut, selon un mode de réalisation particulier, également graver la couche d'arrêt 150.

Comme précédemment, la gravure de la couche d'oxyde 130 peut être réalisée au moyen d'une chimie fluoro-carbonée. On réalise ensuite la gravure de la couche de matériau diélectrique poreux 140 faite de SiOCH, dans un plasma à base d'hydrocarbure et d'azote (N2) et/ou d'oxygène (O2) ; ledit plasma étant avantageusement exempt de tout composé fluoré. De préférence, et dans l'exemple ci-dessous, le plasma comprend uniquement un hydrocarbure, de l'azote et, de manière optionnelle mais avantageuse, de l'argon (Ar) ou de l'hélium (He).

Avantageusement, il s'agit d'une gravure physico-chimique, mettant en jeu à la fois un bombardement ionique et une réaction chimique entre le gaz ionisé (plasma) et la surface exposée au bombardement ionique. Le rôle de l'azote (N₂) est en outre de graver le film de SiOCH poreux.

Le gaz à base d'hydrocarbure, utilisé lors de la gravure plasma, forme une enveloppe protectrice au moins sur les flancs de la couche de matériau diélectrique poreux 140, laissant une couche de protection 115 au moins sur lesdits flancs et le fond.

La couche de protection 115 à base d'hydrocarbure est obtenue à partir d'un plasma constitué en partie d'hydrocarbure. Par hydrocarbure, on entend les composés organiques constitués essentiellement de carbone et d'hydrogène. Les hydrocarbures utilisables dans l'invention sont ceux de la série des alcanes, des alcènes et des alcynes. En particulier, ces hydrocarbures peuvent être saturés ou insaturés. Comme hydrocarbures utilisables dans l'invention, on peut citer l'acétylène, le propadiène, l'éthylène, le butène, le propylène, le méthane, l'éthane, le butane, le propane. De préférence, on choisit le méthane. Selon l'invention, on peut utiliser un hydrocarbure ou un mélange d'hydrocarbures.

Durant cette opération, il y a donc formation d'une couche de protection 115 sur les flancs et le fond de la tranchée 112. La formation de la couche de protection 115 est favorisée par le fait que le bombardement ionique à base d'azote sur les flancs des motifs est faible alors qu'au contraire, sur le fond des motifs, le bombardement retarde la formation de cette couche. Ce bombardement ionique à base d'azote est anisotrope permettant ainsi de graver efficacement le diélectrique poreux 140, tout en conservant un rapport de forme élevé (« aspect ratio » en anglais).

Bien que, selon un mode de réalisation préféré, la chimie de gravure est la même pour la couche de matériau diélectrique poreux 140 et la couche 150 d'arrêt, la couche 150 fait tout de même office de couche d'arrêt. En effet, la vitesse de gravure du matériau de la couche 150 est inférieure à celle du matériau diélectrique poreux de la couche 140, notamment du fait de la porosité de cette couche 140. Selon un mode de réalisation, pour graver la couche d'arrêt 150, faite, par exemple, de carbure de silicium (SiCH), de nitrure de silicium (SiN) ou de carbonitrure de silicium (SiCN). Dans un mode de réalisation préféré, la gravure de cette couche 150 est réalisée au moyen d'une chimie fluoro-carbonée traditionnelle. La gravure de la couche 150 est effectuée, de préférence, dans le même graveur plasma que celui de la couche de matériau diélectrique poreux. La couche de matériau diélectrique poreux 140 de p-SiOCH est, dans ce cas, toujours protégée de toute contamination par la couche de protection 115 qui a été formée lors de l'étape de gravure précédente. Elle n'est donc pas altérée comme dans le procédé conventionnel.

La gravure de la couche 130 d'oxyde, de la couche de matériau diélectrique poreux 140 et de la couche 150 d'arrêt s'arrête, avantageusement sur le matériau métallique 180 formant une ligne métallique d'un premier niveau N-1. En raison de la présence de la couche de protection 115, la gravure se fait sans aucune modification de la couche de matériau diélectrique poreux 140. On emploie préférentiellement un graveur plasma de type ICP ou CCP. De manière avantageuse, on emploie le même équipement que pour la gravure des couches d'oxyde 130, de matériau diélectrique poreux 140 et d'arrêt 150. Les gammes de valeurs avantageuses des conditions de mise en œuvre de cette gravure sont résumées dans le tableau ci-après, sans que l'invention se limite à ces valeurs :

| | |
|---|---|
| Débit CH₄ | 5 - 30 sccm (centimètres cube par minute dans des conditions standard de pression et de température) |
| Débit N₂ | 50 - 200 sccm |
| Puissance bias (contrôle de l'énergie des ions) | 100 Watts - 300 Watts |
| Puissance de la source | Dépend de la dissociation du plasma |
| Pression | 5 - 100 milliTorr |
| Température | 40 - 100°C |

Selon le précédent exemple de réalisation, la porosité du matériau diélectrique 140 est de 25%.

La gravure de la couche de matériau diélectrique poreux 140 repose sur le fait que le SiOCH poreux est gravé suite au bombardement des ions générés par le plasma tandis que la couche de protection 115, faite à base d'hydrocarbure, se crée spontanément sur les flancs et le fond de la tranchée 112. La formation de la couche de protection 115 se fait avec une modification limitée du matériau constituant la couche de matériau diélectrique poreux 140.

L'épaisseur de la couche de protection 115, qui est typiquement comprise dans une plage de valeurs allant de 1 à 5 nm, et, de préférence comprise entre 1 et 2 nm, peut être ajustée en jouant sur les paramètres du plasma durant la gravure.

Les paramètres importants contrôlant la formation de la couche de passivation sont : le rapport C_{X}H_{Y}/N₂, la puissance source et la puissance bias qui permettent de contrôler le taux de dissociation et l'énergie des ions, respectivement, dans le réacteur CCP ou ICP.

Une concentration trop importante de méthane (CH₄) pourrait entrainer un arrêt de la gravure. A l'inverse, une concentration insuffisante en méthane ne permettrait pas de former une couche de protection 115 nécessaire afin de protéger les flancs des tranchées 110. D'autre part, lors du bombardement ionique, l'énergie des ions doit être suffisamment élevée (de préférence comprise entre 100 Wb et 300 Wb) pour éviter que le carbone ne se dépose au fond des tranchées 110, tout en permettant une gravure du matériau diélectrique poreux 140. Cependant, une concentration trop élevée de l'énergie ionique pourrait provoquer une pulvérisation du masque dur à base de TiN, entrainant inévitablement un arrêt de la gravure. En ce qui concerne la température requise lors de la gravure plasma, on privilégie une température comprise entre 40° et 100°C de sorte à éviter, pour de trop faibles températures (typiquement inférieures à 40°C), un dépôt supplémentaire du métal (par exemple, du TiN) contenu dans le masque dur 120, pouvant engendrer par la suite des problèmes de rugosité en surface ainsi qu'un arrêt de la gravure.

Selon un mode de réalisation préférentiel, la gravure de la couche de matériau diélectrique poreux est réalisée à l'aide d'une chimie sans fluor comme un mélange gazeux à base de méthane (CH₄) et d'azote (N₂). Le rôle de l'azote (N₂) est de graver le film de SiOCH poreux. Le problème est que si nous n'utilisons que de l'azote (N₂), le risque est de modifier le flanc suite au bombardement ionique. Par conséquent, le rôle du méthane (CH₄) est de protéger la paroi latérale (composée d'une couche de carbone). Le problème est que si nous n'utilisons que du méthane CH₄, le risque est de ne pas être en mesure de graver le film de SiOCH poreux (arrêt de gravure) en raison du dépôt d'une couche de carbone trop épaisse. Un ajout d'azote N₂ permet également de contrôler le dépôt de carbone C et par ce biais, trouver le compromis entre la ligne de fond de gravure par pulvérisation et la protection latérale avec une couche de carbone sur le flanc. L'azote permet également d'éviter un dépôt trop important de polymères. Selon un mode de réalisation particulièrement avantageux, le ratio de gaz entre le méthane et l'azote doit être compris entre 1:20 et 1:10. Le risque d'utiliser un ratio de mélange gazeux méthane/azote supérieur à 1:10 est d'empêcher la gravure du matériau diélectrique poreux 140. Le risque d'utiliser un ratio de mélange gazeux méthane/azote inférieur à 1:20 est de modifier le matériau diélectrique poreux 140.

D'autres gaz pourraient convenir en remplacement de l'azote (N₂) ; tel est le cas de l'oxygène (O₂), par exemple. Toutefois, l'oxygène (O₂) pourrait entrainer d'importants dommages de la couche de matériau diélectrique poreux 140 tels qu'une modification des flancs ou une augmentation de la constante diélectrique. L'ajout d'oxygène doit donc être de quantité restreinte, dans un ratio optimisé, afin de limiter toute détérioration du matériau diélectrique poreux 140.

La précédente étape de gravure est suivie d'une étape de nettoyage par voie humide. Avantageusement, cette étape de nettoyage ne consomme pas la couche de protection 115 formée sur les flancs de la tranchée 112 de sorte à éviter une modification de la couche de matériau diélectrique poreux 140.

La **figure 3f** illustre la formation d'une couche anti-diffusion 172. Cette couche anti-diffusion 172 est préférentiellement formée en un matériau métallique. Selon un exemple, cette couche 172 comprend un empilement de couches ou bicouche : une première couche en un premier matériau tel que du tantale et une deuxième couche en un deuxième matériau tel que du nitrure de tantale. Cette couche anti-diffusion 172 peut être formée par une technique de déposition en phase vapeur. Avantageusement, la précédente étape de nettoyage par voie humide permet d'améliorer le contact métallique entre la couche anti-diffusion 172 métallique d'un deuxième niveau N et le matériau métallique 180 formant une ligne métallique d'un premier niveau N-1.

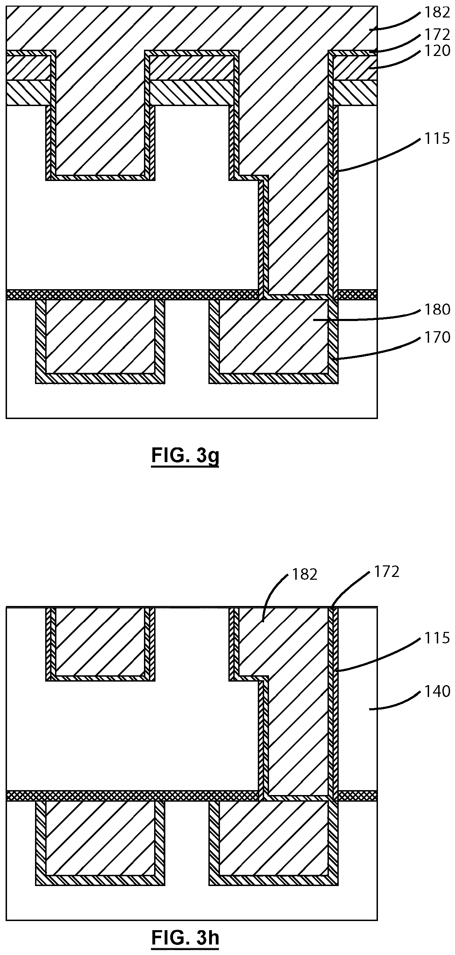

La **figure 3g** illustre l'étape de remplissage des tranchées 112 par une couche 182 en un matériau métallique. Le matériau métallique de la couche 182 est préférentiellement du cuivre.
Selon un mode de réalisation préférentiel, une inclinaison des flancs de la tranchée 112 favorise, lors des opérations de fin de ligne, l'obtention d'un dépôt satisfaisant, d'une part, de la couche 172 faisant barrière à la diffusion du matériau métallique et, d'autre part, de la couche 182 en un matériau métallique destinée à remplir les tranchées 112 pour former des lignes d'interconnexions du deuxième niveau N.

La **figure 3h** illustre une ultime étape pour la réalisation de lignes d'interconnexion comprenant un retrait partiel de la couche 182 en un matériau métallique. Préférentiellement, ce retrait partiel comprend un polissage mécano-chimique. Le polissage mécano-chimique de la couche 182 s'arrête dès que la couche de matériau diélectrique poreux 140 est détectée.

Selon une variante du procédé de l'invention, on n'utilise pas de masque dur métallique 120 ; ainsi les étapes 230 et 240 de la figure 2 sont supprimées. La structure stratifiée 100 qui est déposée à l'étape 210 ne comprend donc plus la couche 120 de nitrure de titane (TiN). C'est la couche 130, de préférence, d'oxyde de silicium qui va alors servir de masque dur. Dans cette variante du procédé, les conditions de gravure de la couche de matériau diélectrique poreux 140, p-SiOCH, sont les mêmes qu'avec le masque dur métallique 120 et comme décrites dans les figures 3d et 3e. Toutefois, le différentiel de gravure entre la couche d'oxyde 130 et la couche de matériau diélectrique poreux 140 p-SiOCH étant moins grand qu'entre le masque dur métallique 120, par exemple de TiN et le matériau diélectrique poreux 140, p-SiOCH, il faut prévoir une consommation de la couche 130 d'oxyde plus importante pendant la gravure et respecter un rapport minimum entre l'épaisseur de la couche de matériau diélectrique poreux 140 à graver et l'épaisseur de la couche 130 d'oxyde. Typiquement, l'épaisseur de la couche 130 d'oxyde sera supérieure au 1/5 de celle de la couche de matériau diélectrique poreux 140. L'épaisseur pour chacune de ces couches 130, 140 est mesurée selon une direction perpendiculaire au plan dans lequel les couches 130, 140 s'étendent. Dans cette variante du procédé, la couche 130, qui sert de masque dur, peut aussi être faite de carbone (C) ou de nitrure de silicium (SiN).

Le remplacement de la gravure traditionnelle de la couche de matériau diélectrique poreux 140 de p-SiOCH par une gravure non fluorée permet avantageusement de ne pas modifier les flancs des tranchées 112 du matériau diélectrique poreux 140 pendant la gravure, et de ne pas former de résidus fluorés qui pourraient éventuellement rendre inutile l'étape de nettoyage par voie humide après la gravure. Dans un procédé standard, ces problèmes entraînent une baisse de fiabilité des dispositifs réalisés. Au contraire, dans le cas de l'invention, la couche de protection 115 à base d'hydrocarbure protège le matériau diélectrique poreux 140 pendant toute la gravure. En outre, cette couche de protection 115 agit comme une barrière de diffusion des précurseurs. Selon un mode de réalisation particulièrement avantageux, on dépose une couche 172 additionnelle, par exemple en métal, sur la couche de protection 115 afin de former des lignes d'interconnexion; la couche de protection 115 restant avantageusement en place.

D'autre part, la variante du procédé dans lequel on s'affranchit de l'utilisation d'un masque dur métallique 120, de préférence en nitrure de titane, permet d'éviter de nombreux problèmes associés. Le procédé, ainsi simplifié, se traduit par une meilleure productivité, à moindre coût.

La présente invention n'est pas limitée aux modes de réalisation précédemment décrits mais s'étend à tout mode de réalisation couvert par les revendications.

## Revendications

1. Procédé pour la réalisation de lignes d'interconnexions comprenant au moins une étape de gravure d'une couche de matériau diélectrique poreux (140) formant une tranchée (112); le matériau diélectrique poreux (140) étant un oxyde de silicium dopé au carbone et à l'hydrogène, SiOCH, poreux, la gravure est réalisée dans un plasma de manière à faire croître tout au long de ladite gravure une couche de protection (115) au moins sur des flancs de la couche de matériau diélectrique poreux (140), **caractérisé en ce que** le plasma est formé à partir d'un gaz formé d'un premier composant et d'un deuxième composant, ou d'un gaz formé d'un premier composant, d'un deuxième composant et d'un troisième composant,
dans lequel : le premier composant est un hydrocarbure de type C_{X}H_{Y}, où X est la proportion de carbone dans le gaz et Y la proportion d'hydrogène, H, dans le gaz ; le deuxième composant est pris parmi l'azote, N₂, ou le dioxygène, O₂, ou un mélange d'azote et de dioxygène ; le troisième composant est pris parmi l'argon, Ar, ou l'hélium, He; le plasma étant exempt de tous composés fluorés; la couche de protection (115) étant à base d'hydrocarbure,
le procédé comprenant, après la gravure de la couche de matériau diélectrique poreux (140) pour former la tranchée (112), une étape ultérieure de remplissage de la tranchée (112) par un matériau électriquement conducteur.

2. Procédé selon la revendication précédente dans lequel le ratio de gaz entre le premier composant et le deuxième composant est compris entre 5% et 20%.

3. Procédé selon la revendication 1 dans lequel le ratio de gaz entre le premier composant et le deuxième composant est supérieur à 1:20 et inférieur à 1:10.

4. Procédé selon l'une quelconque des revendications précédentes dans lequel le gaz à base d'hydrocarbure est le méthane, CH₄.

5. Procédé selon l'une quelconque des revendications précédentes dans lequel la couche de protection (115) à base d'hydrocarbure formée lors de la gravure isole électriquement les flancs du matériau diélectrique poreux.

6. Procédé selon l'une quelconque des revendications précédentes dans lequel on conserve la couche de protection (115) formée lors de la gravure.

7. Procédé selon la revendication précédente dans lequel on dépose une couche additionnelle sur la couche de protection (115).

8. Procédé selon l'une quelconque des revendications précédentes comprenant, avant la gravure de la couche de matériau diélectrique poreux (140), la réalisation d'un masque dur (120, 130) surmontant la couche de matériau diélectrique poreux (140), le masque dur (120, 130) présentant au moins un motif et la gravure de la couche de matériau diélectrique poreux (140) étant effectuée à travers le masque dur (120, 130) pour transférer le motif dans la couche de matériau diélectrique poreux (140), le motif étant la tranchée.

9. Procédé selon la revendication précédente dans lequel le masque dur (130) est fait d'oxyde de silicium SiO₂, de nitrure de silicium, SiN, ou de SiOCH dense.

10. Procédé selon l'une quelconque des deux revendications précédentes dans lequel le masque dur (130) présente une face inférieure au contact de la couche de matériau diélectrique poreux (140) et une face supérieure opposée à la face inférieure et dans lequel ladite face supérieure est au contact du plasma de gravure lors de l'étape de gravure de la couche de matériau diélectrique poreux (140) à travers le masque dur (130) et dans lequel l'épaisseur du masque dur (130) est adaptée pour ne pas être entièrement consommé pendant la gravure plasma de la couche de matériau diélectrique poreux (140).

11. Procédé selon la revendication 8 dans lequel le masque dur (120) est un masque métallique.

12. Procédé selon l'une quelconque des quatre revendications précédentes dans lequel, préalablement à la définition du motif dans le masque dur (120, 130), on dispose, sous la couche de matériau diélectrique poreux (140), une couche d'arrêt (150) conformée pour stopper la gravure de la couche de matériau diélectrique poreux (140), et on effectue après l'étape de gravure de la couche de matériau diélectrique poreux (140), une étape de gravure de la couche d'arrêt (150).

13. Procédé selon l'une quelconque des revendications 8 à 11 dans lequel, préalablement à la définition du motif du masque dur (120, 130), on dispose sous la couche de matériau diélectrique poreux (140) une couche d'arrêt (150) qui, lorsqu'elle est soumise au plasma utilisé pour graver la couche de matériau diélectrique poreux (140), présente une vitesse de gravure inférieure à la vitesse de gravure de la couche de matériau diélectrique poreux (140), et dans lequel on grave la couche d'arrêt (150) à la suite de la gravure de la couche de matériau diélectrique poreux (140) en utilisant ledit plasma.

## Patentansprüche

1. Verfahren zur Herstellung von Verbindungsleitungen, das mindestens einen Schritt des Ätzens einer Schicht aus porösem dielektrischem Material (140) umfasst, der einen Graben (112) bildet; wobei es sich bei dem porösen dielektrischen Material (140) um ein poröses, mit Kohlenstoff und mit Wasserstoff dotiertes Siliziumoxid, SiOCH, handelt, wobei das Ätzen in einem Plasma ausgeführt wird, um während des Ätzens mindestens an Flanken der Schicht aus porösem dielektrischem Material (140) eine Schutzschicht (115) aufwachsen zu lassen, **dadurch gekennzeichnet, dass** das Plasma auf Grundlage eines Gases gebildet wird, das aus einer ersten Komponente und einer zweiten Komponente gebildet ist, oder eines Gases, das aus einer ersten Komponente, einer zweiten Komponente und einer dritten Komponente gebildet ist,
wobei: es sich bei der ersten Komponente um einen Kohlenwasserstoff vom Typ C_{X}H_{Y} handelt, wobei X der Anteil an Kohlenstoff im Gas, und Y der Anteil an Wasserstoff, H, im Gas ist; die zweite Komponente aus Stickstoff, N₂, oder Sauerstoff, O₂, oder einer Mischung aus Stickstoff und Sauerstoff ausgewählt ist; die dritte Komponente aus Argon, Ar, oder Helium, He, ausgewählt ist; wobei das Plasma frei von jeglichen Fluorverbindungen ist,
wobei die Schutzschicht (115) auf Kohlenwasserstoffbasis ist,
wobei das Verfahren nach dem Ätzen der Schicht aus porösem dielektrischem Material (140), um den Graben (112) zu bilden, einen nachfolgenden Schritt des Füllens des Grabens (112) mit einem elektrisch leitfähigen Material umfasst.

2. Verfahren nach dem vorstehenden Anspruch, wobei das Gasverhältnis zwischen der ersten Komponente und der zweiten Komponente zwischen 5 % und 20 % liegt.

3. Verfahren nach Anspruch 1, wobei das Gasverhältnis zwischen der ersten Komponente und der zweiten Komponente größer als 1:20 und kleiner als 1:10 ist.

4. Verfahren nach einem der vorstehenden Ansprüche, wobei es sich bei dem Gas auf Kohlenwasserstoffbasis um Methan, CH₄, handelt.

5. Verfahren nach einem der vorstehenden Ansprüche, wobei die Schutzschicht (115) auf Kohlenwasserstoffbasis, die beim Ätzen gebildet wird, die Flanken des porösen dielektrischen Materials elektrisch isoliert.

6. Verfahren nach einem der vorstehenden Ansprüche, wobei die beim Ätzen gebildete Schutzschicht (115) beibehalten wird.

7. Verfahren nach dem vorstehenden Anspruch, wobei auf der Schutzschicht (115) eine zusätzliche Schicht abgeschieden wird.

8. Verfahren nach einem der vorstehenden Ansprüche, das vor dem Ätzen der Schicht aus porösem dielektrischem Material (140) das Herstellen einer Hartmaske (120, 130) umfasst, die die Schicht aus porösem dielektrischem Material (140) überdeckt, wobei die Hartmaske (120, 130) mindestens ein Muster aufweist, und das Ätzen der Schicht aus porösem dielektrischem Material (140) durch die Hartmaske (120, 130) hindurch erfolgt, um das Muster in die Schicht aus porösem dielektrischem Material (140) zu übertragen, wobei es sich bei dem Muster um den Graben handelt.

9. Verfahren nach dem vorstehenden Anspruch, wobei die Hartmaske (130) aus Siliziumoxid, SiO₂, Siliziumnitrid, SiN, oder dichtem SiOHC besteht.

10. Verfahren nach einem der zwei vorstehenden Ansprüche, wobei die Hartmaske (130) eine untere Seite aufweist, die sich mit der Schicht aus porösem dielektrischem Material (140) in Kontakt befindet, und eine obere Seite, die der unteren Seite gegenüberliegt, und wobei sich die obere Seite beim Schritt des Ätzens der Schicht aus porösem dielektrischem Material (140) durch die Hartmaske (130) hindurch mit dem Ätzplasma in Kontakt befindet, und wobei die Dicke der Hartmaske (130) so angepasst ist, dass sie während des Plasmaätzens der Schicht aus porösem dielektrischem Material (140) nicht vollständig verbraucht wird.

11. Verfahren nach Anspruch 8, wobei es sich bei der Hartmaske (120) um eine Metallmaske handelt.

12. Verfahren nach einem der vier vorstehenden Ansprüche, wobei vor dem Definieren des Musters in der Hartmaske (120, 130) unter der Schicht aus porösem dielektrischem Material (140) eine Stoppschicht (150) angeordnet wird, die so ausgebildet ist, dass sie das Ätzen der Schicht aus porösem dielektrischem Material (140) stoppt, und nach dem Schritt des Ätzens der Schicht aus porösem dielektrischem Material (140) ein Schritt des Ätzens der Stoppschicht (150) erfolgt.

13. Verfahren nach einem der Ansprüche 8 bis 11, wobei vor dem Definieren des Musters der Hartmaske (120, 130) unter der Schicht aus porösem dielektrischem Material (140) eine Stoppschicht (150) angeordnet wird, die, wenn sie dem zum Ätzen der Schicht aus porösem dielektrischem Material (140) verwendeten Plasma ausgesetzt ist, eine Ätzgeschwindigkeit aufweist, die niedriger ist als die Ätzgeschwindigkeit der Schicht aus porösem dielektrischem Material (140), und wobei die Stoppschicht (150) im Anschluss an das Ätzen der Schicht aus porösem dielektrischem Material (140) unter Verwendung des Plasmas geätzt wird.

## Claims

1. Method for producing interconnection lines, comprising at least one step of etching a layer of porous dielectric material (140) forming a trench (112), the porous dielectric material (140) being a porous silicon oxide doped with carbon and hydrogen, SiOCH, the etching is performed in a plasma so as to grow, all along said etching, a protective layer (115) at least on flanks of the layer of porous dielectric material (140), **characterised in that** the plasma is formed from a gas formed from a first component and a second component, or a gas formed from a first component, a second component and a third component,
wherein: the first component is a hydrocarbon of the C_{X}H_{Y} type, where X is the proportion of carbon in the gas and Y the proportion of hydrogen, H, in the gas; the second component is taken from nitrogen, N₂, dioxygen, O₂, or a mixture of nitrogen and dioxygen; the third component is taken from argon, Ar, or helium, He; the plasma being free from any fluorinated compounds,
the protective layer (115) being based on hydrocarbon,
the method comprising, after the etching of the layer of porous dielectric material (140) in order to form the trench (112), a subsequent step of filling the trench (112) with an electrically conductive material.

2. Method according to the preceding claim, wherein the gas ratio between the first component and the second component is between 5% and 20%.

3. Method according to claim 1, wherein the gas ratio between the first component and the second component is greater than 1:20 and less than 1:10.

4. Method according to any one of the preceding claims, wherein the hydrocarbon-based gas is methane, CH₄.

5. Method according to any one of the preceding claims, wherein the hydrocarbon-based protective layer (115) formed during the etching electrically insulates the flanks of the porous dielectric material.

6. Method according to any one of the preceding claims, wherein the protective layer (115) formed during the etching is preserved.

7. Method according to the preceding claim, wherein an additional layer is deposited on the protective layer (115).

8. Method according to any one of the preceding claims, comprising, before etching the layer of porous dielectric material (140), the production of a hard mask (120, 130) surmounting the layer of porous dielectric material (140), the hard mask (120, 130) having at least one pattern and the layer of porous dielectric material (140) being etched through the hard mask (120, 130) in order to transfer the pattern into the layer of porous dielectric material (140), the pattern being the trench.

9. Method according to the preceding claim, wherein the hard mask (130) is made from silicon oxide, SiO₂, silicon nitride, SiN, or dense SiOCH.

10. Method according to either one of the preceding two claims, wherein the hard mask (130) has a bottom face in contact with the layer of porous dielectric material (140) and a top face opposite to the bottom face and wherein said top face is in contact with the etching plasma during the step of etching the layer of porous dielectric material (140) through the hard mask (130), and wherein the thickness of the hard mask (130) is adapted so as not to be entirely consumed during the plasma etching of the layer of porous dielectric material (140).

11. Method according to claim 8, wherein the hard mask (120) is a metal mask.

12. Method according to any one of the preceding four claims, wherein, prior to defining the pattern in the hard mask (120, 130), a stop layer (150) conformed to stop the etching of the layer of porous dielectric material (140) is arranged under the layer of porous dielectric material (140), and, after the step of etching the layer of porous dielectric material (140), a step of etching the stop layer (150) is performed.

13. Method according to any one of claims 8 to 11, wherein, prior to defining the pattern of the hard mask (120, 130), a stop layer (150) is disposed under the layer of porous dielectric material (140), said stop layer, when it is subjected to the plasma used for etching the layer of porous dielectric material (140), has an etching speed less than the etching speed of the layer of porous dielectric material (140), and wherein the stop layer (150) is etched following the etching of the layer of porous dielectric material (140) using said plasma.
